Europäisches Patentamt

European Patent Office

Office européen des brevets

(11) Numéro de publication: **0 275 587 B1**

# (12) FASCICULE DE BREVET EUROPEEN

(45) Date de publication de fascicule du brevet: **30.09.92**  (51) Int. Cl.⁵: **H03F 3/72**, H03F 3/19

(21) Numéro de dépôt: **87202495.5**

(22) Date de dépôt: **14.12.87**

(54) **Commutateur électronique à très haute fréquence.**

(30) Priorité: **19.12.86 FR 8617863**

(43) Date de publication de la demande:
**27.07.88 Bulletin  88/30**

(45) Mention de la délivrance du brevet:
**30.09.92 Bulletin  92/40**

(84) Etats contractants désignés:
**DE ES FR GB IT**

(56) Documents cités:
**DE-A- 2 355 512**
**DE-B- 1 297 703**
**FR-A- 2 254 158**
**US-A- 3 475 759**
**US-A- 4 465 979**

(73) Titulaire: **PHILIPS ELECTRONIOUE GRAND PU-
BLIC**
**51, Rue Carnot**
**F-92150 Suresnes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE ES GB IT**

(72) Inventeur: **Maitre, Thierry Société Civile
S.P.I.D.**
**209, rue de l'Université**
**F-75007 Paris(FR)**

(74) Mandataire: **Caron, Jean et al**
**Société Civile S.P.I.D. 156, Boulevard Haussmann**
**F-75008 Paris(FR)**

Rank Xerox (UK) Business Services

## Description

L'invention concerne un commutateur électronique pour la commutation de signaux de télévision dans une gamme de fréquences allant d'environ un gigaherz jusqu'à environ deux gigaherz, comportant deux voies ou plus dont chacune est munie d'une entrée, chacune des voies étant munie d'un amplificateur et les sorties de toutes les voies délivrant un signal sur une même borne de sortie.

Un tel commutateur est utilisé notamment dans des dispositifs de réception de télévision par satellite. Selon le standard défini pour de telles réceptions, deux canaux sont transmis simultanément selon deux polarisations différentes et la tête de réception transmet à un syntoniseur les deux signaux correspondant chacun à une des polarisations. Le commutateur selon l'invention peut être utilisé pour sélectionner la réception de l'un de ces deux signaux.

Un circuit de ce genre est connu du document US-A-3 475 759. Il comporte deux voies dont chacune est munie d'une entrée, chacune des voies étant munie d'un amplificateur et les sorties des deux voies délivrant un signal sur une même borne de sortie. Chacun des amplificateurs est chargé par un circuit d'adaptation d'impédance relativement complexe et polarisé au moyen de circuits d'émetteur également complexes, bien que chaque voie amplifie une gamme de fréquences différente ce qui facilite l'adaptation grâce à la spécialisation de chaque voie.

Le propos de la présente invention est de fournir un commutateur pour sélectionner l'une des deux voies, en isolant l'autre, les voies véhiculant toutes deux des signaux dans la même gamme de fréquences, située aux alentours de 1 à 2 GHz, et en recherchant à la fois une grande simplicité, et la meilleure isolation possible pour la voie isolée.

A cet effet, le commutateur selon l'invention est remarquable en ce que, chaque amplificateur pouvant à la demande soit amplifier soit isoler un signal appliqué à son entrée et comportant un étage d'entrée adaptateur d'impédance et un étage d'amplification proprement dit, ce dernier est muni en sortie d'un transistor monté en émetteur commun et l'émetteur de ce dernier est directement connecté à la masse, et les sorties de tous les étages d'amplification sont directement connectées ensemble à un point commun qui est relié à un étage de charge et d'adaptation d'impédance commun à toutes les voies.

Par les mots "directement connecté" on entend qu'ils sont reliés galvaniquement à un point commun et qu'aucun dispositif d'adaptation d'impédance n'est connecté entre ce point commun et l'amplificateur. Cette solution présente l'avantage d'une grande simplicité, et en outre elle n'est pas limitée à la fabrication d'un commutateur à deux voies mais on peut imaginer de placer de la même façon autant de voies à commuter qu'on le désire. En outre on a constaté que le fait de relier directement les émetteurs à la masse augmente de manière surprenante les performances d'isolation.

Selon un mode particulier de réalisation, un commutateur selon l'invention est remarquable en ce que les collecteurs desdits transistors montés en emetteur commun sont connectés audit point commun, ledit étage de charge et d'adaptation étant relié à une source d'alimentation pour fournir du courant auxdits collecteurs.

Dans une autre variante, le commutateur est remarquable en ce que les collecteurs desdits transistors montés en emetteur commun sont reliés chacun à une source d'alimentation via une résistance de fixation de potentiel, et sont reliés chacun via une diode audit point commun, ledit étage de charge et d'adaptation étant relié à une source d'alimentation pour fournir du courant auxdits collecteurs, via les diodes qui sont branchées dans le sens passant pour ledit courant.

La description qui va suivre, décrivant deux exemples de réalisation de l'invention avec référence aux dessins annexés permettra de mieux comprendre l'invention.

La figure 1 représente très schématiquement un amplificateur à très hautes fréquences à gain commandable connu.

La figure 2 représente un assemblage connu de deux amplificateurs selon la figure 1, constituant un commutateur.

La figure 3 représente très schématiquement l'assemblage de deux amplificateurs pour constituer un commutateur selon l'invention.

La figure 4 représente le schéma électrique détaillé d'un premier mode de réalisation de l'invention.

La figure 5 représente le schéma électrique detaillé d'un second mode de réalisation de l'invention.

La figure 6 représente le schéma électrique détaillé d'un circuit de commande de gain pour les circuits des figures 4 et 5.

La figure 7 représente à l'échelle un schéma de réalisation pratique d'un circuit qui comprend les éléments réunis des figures 5 et 6.

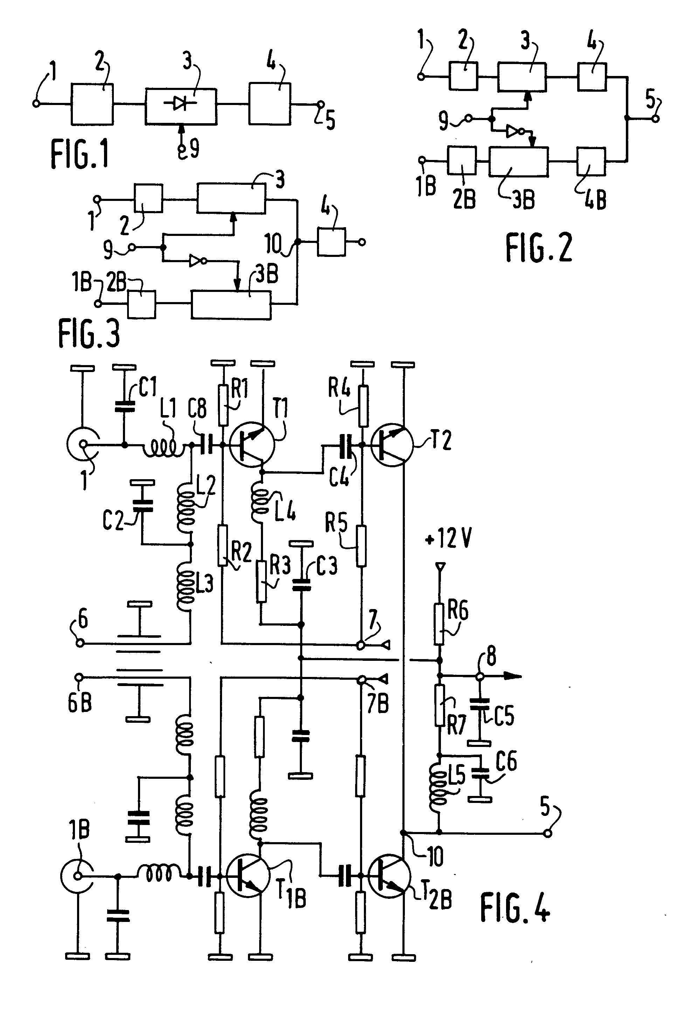

Dans le circuit de la figure 1, un signal d'entrée est appliqué à une borne 1, qui est reliée à un circuit 2 d'adaptation d'impédance, suivie d'un étage d'amplification proprement dit 3 dont le gain peut être réglé au moyen d'une tension de commande appliquée à la borne 9, entre une valeur minimale qui correspond à un état ou le signal est isolé, et une valeur maximale qui correspond à un état ou le signal est amplifié, et qui est suivi enfin d'un circuit 4 d'adaptation d'impédance délivrant le signal amplifié à une borne de sortie 5. On définit l'isolation par la différence entre le gain maximal et le gain minimal.

Sur la figure 2, de façon un commutateur est constitué par l'association d'un premier circuit 1 à 4 et d'un deuxième circuit 1B à 4B correspondant chacun au schéma de la figure 1.

La tension de commande appliquée à la borne 9 est appliquée directement au premier circuit et après inversion, au deuxième circuit, de façon que l'un soit dans l'état où le signal est isolé, alors que l'autre est dans l'état amplificateur.

Les deux circuits sont réunis en sortie. A des fréquences très élevées un tel montage connu présente un grave inconvénient. Supposons par exemple que la voie B soit dans l'état isolant ; le circuit 4B d'adaptation d'impédance présente en parallèle sur la sortie de l'autre circuit 4 une impédance variable avec la fréquence, qui peut comporter des zéros et constitue un circuit trappe, à cause duquel le signal utile est perturbé.

Bien entendu s'il y avait plus de deux voies il y aurait plus d'un circuit perturbateur, et le problème serait encore plus difficile à résoudre.

La figure 3 représente un commutateur selon l'invention, dans lequel sont présentes deux voies respectivement 2, 3 et 2B, 3B dont chacune peut à la demande soit amplifier soit isoler un signal appliqué à son entrée respectivement 1 et 1B, chaque voie comportant un étage d'entrée adaptateur d'impédance 2, 2B, et un étage d'amplification proprement dit 3, 3B. Les sorties des étages d'amplification 3, 3B sont directement connectées ensemble à un point commun 10 qui est relié à un étage de charge et d'adaptation d'impédance 4 commun à toutes les voies. Un tel commutateur est plus simple que le commutateur connu. L'impédance présentée par la sortie de l'amplificateur isolant est une simple capacité de faible valeur qui vient en parallèle sur celle de la sortie de la voie passante et ne produit aucun effet gênant : il suffit d'en tenir compte dans la détermination du circuit d'adaptation commun. En outre on peut sans difficulté prévoir plus de deux voies.

Sur la figure 4 chaque étage d'amplification de voie proprement dit comporte en sortie un transistor T2 ou T2B monté en émetteur commun et les collecteurs de ce transistor sont connectés au point commun 10. L'étage de charge et d'adaptation est constitué d'une inductance L5 reliée d'un côté à la connexion 10 et de l'autre à la masse par une capacité C6, et à une source de tension d'alimentation +12V via deux résistances en série R7 et R6 dont le point commun 8 est découplé par une capacité C5 reliée à la masse. Le chemin passant par R6, R7, L5 permet de fournir du courant au collecteur des transistors T2, T2B. La liaison entre les sorties des amplificateurs représentées ici par les collecteurs des transistors T2, T2B est tout à fait directe, la connexion 10 n'étant munie d'aucun dispositif adaptateur d'impédance afférent à une seule voie. L'impédance ici adaptée par l'étage de charge et d'adaptation est déterminée en fonction des étages suivants et cette adaptation peut donc être ajustée différemment suivant les cas.

Le signal d'une voie est présenté à l'entrée 1 et transmis à la base d'un premier transistor T1, dont l'émetteur est directement connecté à la masse, via un dispositif d'adaptation d'impédance constitué par la capacité C1 connectée entre l'entrée 1 et la masse, une capacité série C8 et une inductance série L1 ainsi que par les éléments L2, L3, C2 qui seront expliqués plus loin. Les différents composants sont placés dans un boîtier métallique fermé et le symbole circulaire qui entoure la borne 1 indique que l'on pénètre en ce point dans le boîtier. Le signal est transmis à la base de T1 par la capacité C8. Le collecteur de T1 est chargé par une inductance L4 en série avec une résistance R3 qui est reliée de l'autre côté à la source d'alimentation disponible sur la connexion 8, et à une capacité de découplage C3 reliée à la masse.

Le collecteur de T1 est relié à la base d'un deuxième transistor T2 monté en cascade avec lui, via une capacité de liaison C4. Le deuxième transistor T2 a lui aussi son émetteur directement connecté à la masse, et son collecteur constitue la sortie de l'amplificateur déjà mentionnée.

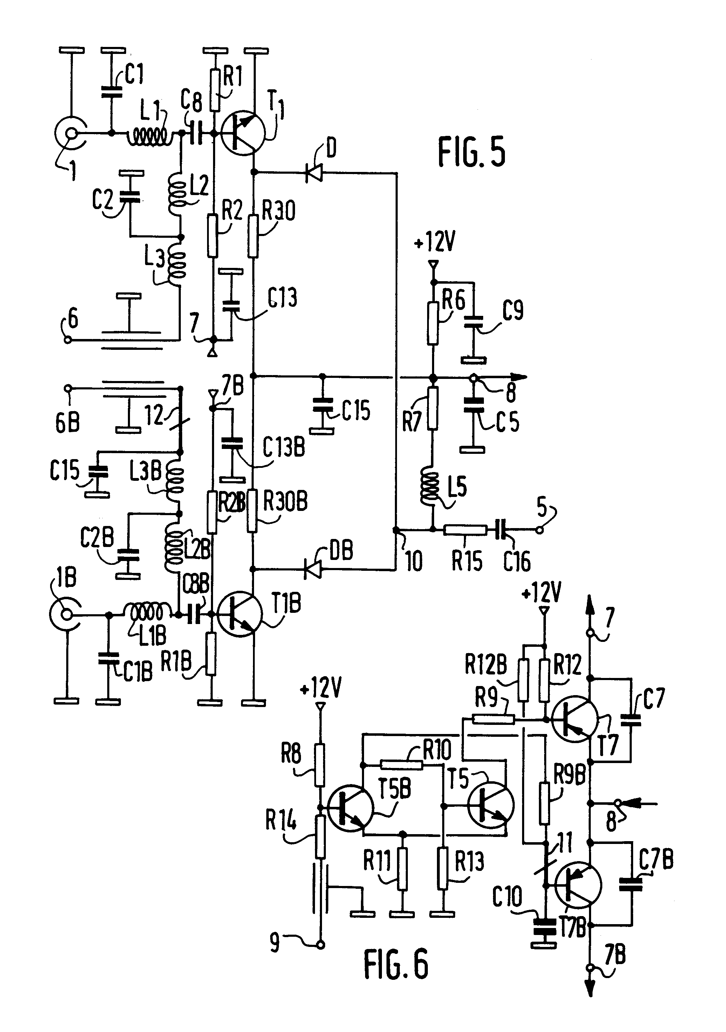

Les bases des deux transistors T1 et T2 sont polarisées ensemble par un même circuit qui sera décrit plus loin en référence à la figure 6. Ce circuit commande l'amplification par action sur la polarisation des bases des transistors T1, T2. A cet effet chacune de ces bases est reliée à la masse par une résistance respectivement R1 ou R4 et est reliée par une résistance respectivement R2 ou R5 à une borne 7 d'entrée de commande de gain, elle-même reliée au circuit de la figure 6.

La borne 6 est une entrée d'alimentation qui permet, à l'aide des éléments L3, C2, L2 qui ne font pas partie de l'invention d'envoyer dans une ligne branchée à la borne 1 un courant d'alimentation, tout en présentant l'impédance voulue pour le signal. Cette alimentation est destinée à une tête de réception habituellement située sur le toit des immeubles avec l'antenne de réception.

Sur la moitié inférieure de la figure sont représentés les éléments de la deuxième voie, avec une borne d'entrée de signal 1B, des transistors d'amplification réglable T1B, T2B. Les éléments de cette voie sont en tout point identiques à ceux de la première voie décrits ci-dessus et n'ont donc pas besoin d'être décrits à nouveau.

Le collecteur du transistor de sortie T2B est directement relié à celui du transistor T2 de la première voie par une connexion 10 laplus courte possible, et l'étage de charge et de polarisation L5, C6, R7, C5 qui est relié à cette connexion 10 est commun au deux voies.

La figure 5 représente une autre forme de réalisation préférée de l'invention. Chaque amplificateur ne comporte qu'un étage à transistor, et l'isolation est maintenue au même niveau que dans le montage précédent grâce à une diode D ou DB (diode dite PIN) qui est bloquée lorsque la voie est dans l'état isolant.

Les éléments compris entre la borne d'entrée 1 et la sortie du transistor T1 sont les mêmes que ceux de la figure 4, et portent les mêmes références. Ici c'est le collecteur de T1 qui constitue la sortie de l'amplificateur proprement dit. Un condensateur de découplage C13 est présent au niveau de la borne 7 d'entrée de commande de gain.

La diode D relie le collecteur du transistor T1 à la borne 10 de l'étage de charge et d'adaptation, dont les références L5, R7, C5, et le fonctionnement sont les mêmes que dans le cas de la figure 4. L'anode de la diode D est du côté de la borne 10 et sa cathode du côté du transistor T1, elle est donc dans le sens passant pour le courant du transistor T1. Le collecteur de T1 est relié en outre à la borne d'alimentation 8 par une résistance R30 qui n'est pas un élément de charge et d'adaptation d'impédance. Son rôle est de fixer le potentiel du collecteur au potentiel du point 8 lorsque le transistor T1 est bloqué et isole le signal. Alors la diode D est également bloquée, et la capacité de sa jonction est intercalée en série dans le chemin du signal ce qui accroît l'isolation.

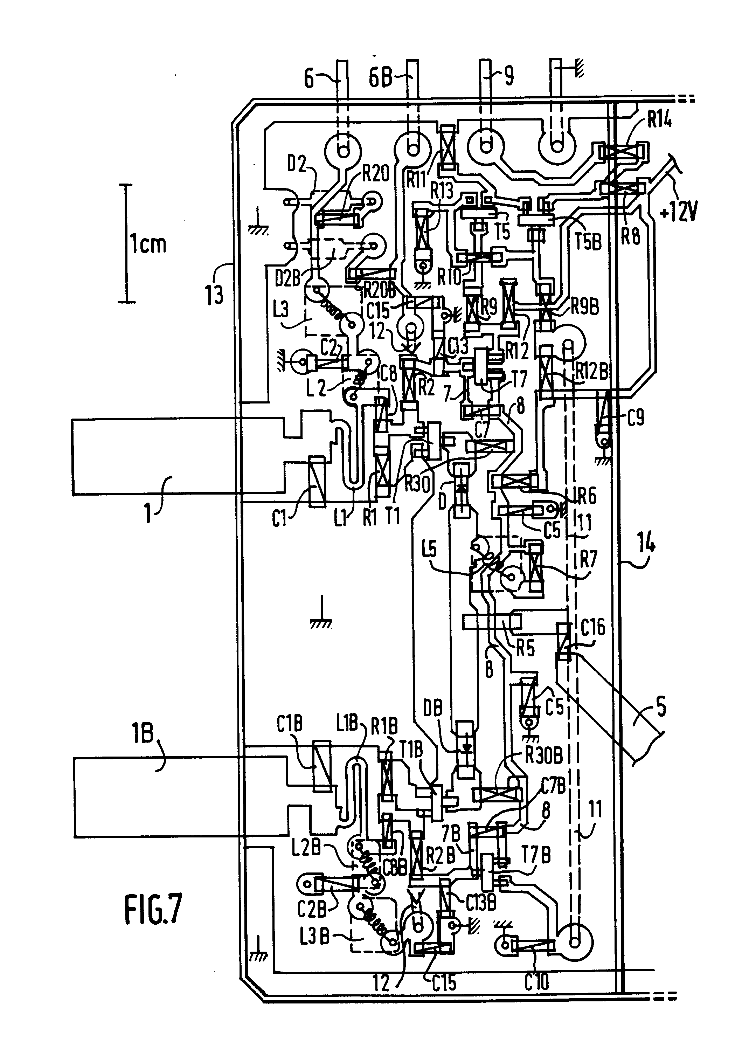

Ici encore les éléments de la deuxième voie sont identiques à ceux de la première et leurs références sont les mêmes avec un indice B. Toutefois les références 12, C15 indiquent des éléments matériels de connexion particuliers à la deuxième voie et qui seront explicités à propos du schéma de câblage de la figure 7. Grâce à l'indice B, il est possible de repérer sur le plan de câblage de la figure 7 quels éléments appartiennent à une voie ou à l'autre. L'anode de la diode DB de la deuxième voie est directement reliée à celle de la diode D de la première voie et à la connexion 10 de l'étage de charge et d'adaptation d'impédance. Le signal de sortie est transmis à d'autres circuits non représentés via une capacité C16 et une résistance R15 en série, qui contribuent eux aussi à l'adaptation d'impédance.

On retrouve sur la figure 6 les deux connexions 7 et 7B des figures 4 et 5. Chacune est reliée au collecteur d'un transistor respectivement T7, T7B dont l'émetteur est relié à la borne d'alimentation 8, l'espace émetteur-collecteur est découplé par un condensateur respectivement C7, C7B, pour éviter tout risque d'oscillation et chaque base est reliée d'une part à l'alimentation +12V par une résistance respectivement R12, R12B et au collecteur d'un autre transistor respectivement T5, T5B par une résistance respectivement R9, R9B. Les deux transistors T5, T5B sont montés de façon connue dite "trigger de Schmitt", avec leurs émetteurs interconnectés et reliés ensemble à la masse par une résistance R11, la base de T5 étant reliée au collecteur de T5B par une résistance R10 et à la masse par une résistance R13. La base de T5B est connectée au point commun de deux résistances R8, R14 en série entre l'alimentation +12V et une borne 9 de commande du commutateur.

Si la tension sur cette borne est basse, les transistors T5 et T7 sont conducteurs, et par conséquent T1 est passant ainsi que D, alors que les transistors T5B, T7B et les éléments actifs de la deuxième voie indicés B sont bloqués et la deuxième voie est isolante. Si la tension à la borne 9 est élevée, l'inverse se produit.

La référence 11 près de la base de T7B indique une connexion réalisée par un fil dans le câblage du circuit. Ce fil relativement long est découplé du côté de la base de T7B par un condensateur C10.

La figure 7 représente la réalisation matérielle des circuits des figures 5 et 6 à une échelle qui est indiquée sur le dessin au moyen d'une référence "1cm". Ce dispositif est réalisé sur une plaque de circuit imprimé double face à trous métallisés et placé dans un boîtier dont la paroi extérieure perpendiculaire au circuit est indiquée par 13, et une cloison intérieure séparant le commutateur vis à vis d'autres circuits non décrits est indiquée par 14. Les constituants de cette réalisation portent les mêmes références que dans les figures 5 et 6. Il est donc inutile de décrire à nouveau les interconnexions. Pratiquement tous les constituants sont des composants dits "à montage en surface" ou "CMS" et sont montés à plat sur les connexions de cuivre du circuit imprimé telles que représentées. Les inductances L1, L1B sont imprimées sur le circuit. Seules les inductances L2, L2B, L3, L3B, L5 sont des éléments discrets munis de connexions traversant le circuit imprimé. Ces éléments sont donc situés sur la face opposée à celle représentée. Cette autre face est pratiquement entièrement métallisée de façon à constituer un plan de masse, sauf en quelques endroits où de la place est réservée pour des connexions traversantes non reliées à la massse, notamment celle des inductances en éléments discrets. Les différents points indiqués sur le dessin comme étant reliés à la masse sont reliés par un trou métallisé à la deuxième face c'est-àdire au plan de masse. Les éléments de plan de masse situés du côté des composants CMS sont munis sur leur pourtour d'une ligne de trous métallisés (non représentés) pour assurer une mise à la masse efficace.

Les bornes d'entrée 1, 1B sont des lamelles métalliques dont la largeur est déterminée par des considérations d'adaptation d'impédance (Zc = 75Ω). Les entrées 6, 6B, 9 et la masse de l'alimentation sont groupées (en haut du dessin) et les connexions 6, 6B sont, près de l'entrée dans le boîtier, reliées à la masse par des diodes de sécurité D2, D2B, en série avec des résistances R20, R20B de 22Ω.

Les éléments référencés 12 sur la figure 5, et 11 sur la figure 6 sont des fils de câblage situés sur la face opposée à celle qui porte la plupart des constituants. Le fil 11 est représenté en pointillé sur la figure 7. Quant au fil 12, pour ne pas encombrer la figure seuls ses points de départ et d'arrivée sont indiqués par des flèches. Ce fil 12 relie la métallisation de l'entrée 6B en haut de la figure, et le point commun à L3B et C15 en bas de la figure. Du fait de l'inductance parasite de ces fils relativement longs, qui doivent être des connexions "froides", leur extrémité est découplée vers la masse au moyen des capacités C15 et C10, respectivement pour les fils 12 et 11. La capacité C15 est divisée en deux composants chacun à une extrémité du fil.

Les composants utilisés dans les circuits des figures 5, 6, 7 ont par exemple les valeurs suivantes :

| | |
|---|---|
| C1 = 0,5 pF | R1 = 1 kΩ |
| C2 = 10 pF. | R2 = 2,2 kΩ |
| C5 = 2 x 100 pF | R30 = 10 kΩ |
| C7, C7B = 47 nf | R6 = 100Ω |
| C8 = 5 pF | R7 = 47Ω |
| C9 = 100 pF | R8 = 100 kΩ |
| C10 = 100 pF | R9, R9B = 6,8 kΩ |
| C15 = 2 x 100 pF | R10 = 82 kΩ |
| | R11 = 1,2 kΩ |
| T1 = BFR 92A | R12, R12B = 2,2 kΩ |
| T1B = BFR 92AR | R13 = 47 kΩ |
| D, DB = BA 679 | R14 = 5,6 kΩ |
| T5 = BC848BR | |
| T5B = BC848B | L2 1,5 spire cuivre 50/100° diamètre intérieur 2mm. |
| T7 = BC858BR | L3 5,5 spires cuivre 50/100° diamètre intérieur 2,5mm. |
| T7B = BC858B. | L5 1,5 spire cuivre 50/100° diamètre intérieur 3mm. |

Les performances du montage des figures 5 et 7 sont les suivantes :
- bande de fréquences utiles : 900 à 1800 MHz.
- impédance d'une entrée : 75Ω.
- isolation de la voie isolante ≧ 35 dB.
- gain d'une voie active ≧ 8 dB.
- taux d'ondes stationnaires typique : 1,5.
- compatibilité TTL pour la commande (borne 9)

Jusqu'à présent, de telles performances ne pouvaient être atteintes qu'au moyen de relais coaxiaux, ou bien de montages utilisant des diodes PIN professionnelles de coût élevé.

Bien entendu, des variantes à ce montage sont possibles sans sortir du cadre de l'invention. Par exemple les transistors T1, T2 pourraient être remplacés moyennant une adaptation des polarisations, à la portée de l'homme du métier, par des transistors MOS. Il conviendrait alors de lire respectivement grille, source, drain au lieu de base, émetteur, collecteur.

**Revendications**

1. Commutateur électronique pour la commutation de signaux de télévision dans une gamme de fréquences allant d'environ un gigaherz jusqu'à environ deux gigaherz, comportant deux voies ou plus dont chacune est munie d'une entrée (1 ou 1B), chacune des voies étant munie d'un amplificateur (2, 3 ou 2B, 3B) et les sorties de toutes les voies délivrant un signal sur une même borne de sortie (5), caractérisé en ce que, chaque amplificateur pouvant à la demande soit amplifier soit isoler un signal appliqué à son entrée et comportant un étage d'entrée adaptateur d'impédance (2 ou 2B) et un étage d'amplification proprement dit (3 ou 3B), ce dernier est muni en sortie d'un transistor (figure 4 : T2 ou T2B, figure 5 : T1 ou T1B) monté en émetteur commun et l'émetteur de ce dernier est directement connecté à la masse, et les sorties de tous les étages d'amplification (3 ou 3B) sont directement connectées ensemble à un point commun (10) qui est relié à un étage de charge et d'adaptation d'impédance (L5, R7) commun à toutes les voies.

2. Commutateur électronique selon la revendication 1, caractérisé en ce que les collecteurs desdits transistors montés en emetteur commun (figure 4 : T2 ou T2B) sont connectés audit point commun (10), ledit étage de charge et d'adaptation (L5, R7) étant relié à une source d'alimentation (+12V) pour fournir du courant auxdits collecteurs.

3. Commutateur électronique selon la revendication 1, caractérisé en ce que les collecteurs desdits transistors montés en emetteur commun (figure 5 : T1 ou T1B) sont reliés chacun à une source d'alimentation (8) via une résistance de fixation de potentiel (R30 ou R30B), et sont reliés chacun via une diode (D ou DB) audit point commun (10), ledit étage de charge et d'adaptation (L5, R7) étant relié à une source d'alimentation (8) pour fournir du courant auxdits collecteurs, via les diodes (D ou DB) qui sont branchées dans le sens passant pour ledit courant.

4. Commutateur électronique selon la revendication 2, dont chaque étage d'amplification comporte deux transistors en cascade (figure 4, T1, T2 ou T1B, T2B), caractérisé en ce que les deux transistors ont tous deux leurs émetteurs directement connectés à la masse, et sont reliés l'un à l'autre par une liaison capacitive (C4), et en ce que leurs bases sont polarisées toutes deux ensemble par un même circuit (figure 6), ce dernier commandant l'amplification de l'amplificateur par action sur la polarisation desdites bases.

**Claims**

1. An electronic switching device for switching television signals in a frequency range of approximately one gigaherz to approximately two gigaherz, comprising two paths or more, each of which has an input (1 or 1B), each path being provided with an amplifier (2, 3 or 2B, 3B) and the outputs of all paths supplying a signal at one and the same output terminal (5), characterized in that since each amplifier can, as required, either amplify or isolate a signal applied to its input and comprises an impedance matching input stage (2 or 2B) and an amplifier stage (3 or 3B), the latter is provided at its output with a transistor (Fig. 4: T2 or T2B; Fig. 5: T1 or T1B) arranged in a common emitter configuration and the emitter of said transistor is directly connected to ground, and the outputs of all amplifier stages (3 or 3B) are directly connected to a common point (10) which is connected to an impedance matching and loading stage (L5, R7) which is common for all the paths.

2. An electronic switching device as claimed in Claim 1, characterized in that the collectors of said transistors (Fig. 4: T2 or T2B) arranged in a common emitter configuration are connected to said common point (10), said matching and loading stage (L5, R7) being connected to a supply source (+12V) for supplying a current to said collectors.

3. An electronic switching device as claimed in Claim 1, characterized in that the collectors of said

EP 0 275 587 B1

transistors (Fig. 5: T1 or T1B) arranged in a common emitter configuration are each connected to a supply source (8) *via* a resistor for fixing the potential (R30 or R30B) and are each connected *via* a diode (D or DB) to said common point (10), said matching and loading stage (L5, R7) being connected to a supply source (8) for supplying the current to said collectors *via* the diodes (D or DB) which are forward-biased for said current.

4. An electronic switching device as claimed in Claim 2 in which each amplifier stage comprises two transistors arranged in cascade (Fig. 4, T1, T2 or T1B, T2B), characterised in that the two transistors have their emitters connected directly to ground and are mutually connected by means of a capacitive connection (C4) and in that their bases are polarized by means of one and the same circuit (Fig. 6), which circuit controls the amplification of the amplifier by varying the polarization of said bases.

**Patentansprüche**

1. Elektronische Schaltanordnung zum Schalten von Fernsehsignalen in einem Frequenzbereich von etwa ein Gigaherz bis etwa zwei Gigaherz, mit mindestens zwei Signalstrecken, die mit je einem Eingang (1 oder 1B) und einem Verstärker (2, 3 oder 2B, 3B) versehen sind und wobei die Ausgänge jeder der Strecken an ein und derselben Ausgangsklemme (5) ein Signal liefern, dadurch gekennzeichnet, daß jeder Verstärker auf Wunsch ein dem Eingang zugeführtes Signal entweder verstärken oder isolieren kann und eine Impedanzanpaß-Eingangsstufe (2 oder 2B) sowie eine eigentliche Verstärkerstufe (3 oder 3B) aufweist, wobei diese letztere am Ausgang mit einem emittergeschalteten Transistor (Fig. 4 : T2 oder T2B, Fig. 5 : T1 oder T1B) versehen ist, und wobei der Emitter dieses Transistors direkt mit Masse verbunden ist, und wobei die Ausgänge aller Verstärkerstufen (3 oder 3B) zusammen mit einem gemeinsamen Punkt (10) direkt verbunden sind, der mit einer allen Strecken gemeinsamen Ladungs- und Impedanzanpaßstufe (L5, R7) verbunden ist.

2. Elektronische Schaltanordnung nach Anspruch 1, dadurch gekennzeichnet, daß die Kollektor-Elektroden der genannten emittergeschalteten Transistoren (Fig. 4 : T2 oder T2B) mit dem gemeinsamen Punkt (10) verbunden sind, wobei die genannte Lade- und Apaßstufe (L5, R7) mit einer Speisequelle (+12V) verbunden ist zum Liefern von Strom zu den genannten Kollektor-Elektroden.

3. Elektronische Schaltanordnung nach Anspruch 1, dadurch gekennzeichnet, daß die Kollektor-Elektroden der genannten emittergekoppelten Transistoren (Fig. 5 : T1 oder T1B) über einen Potentialfestlegungswiderstand (R30 oder R30B) mit je einer Speisequelle (8), und je über eine Diode (D oder DB) mit dem gemeinsamen Punkt (10) verbunden sind, wobei die Lade- und Anpaßstufe (L5, R7) mit einer Speisequelle (8) zum Liefern von Strom zu den genannten Kollektor-Elektroden verbunden ist, und zwar über die Dioden (D oder DB), die in der Durchlaßrichtung für den genannten Strom geschaltet sind.

4. Elektronische Schaltanordnung nach Anspruch 2, bei der jede Verstärkerstufe zwei kaskadengeschaltete Transistoren (Fig. 4, T1, T2 oder T1B, T2B) aufweist, dadurch gekennzeichnet, daß die Emitter der beiden Transistoren direkt an Masse liegen und durch eine kapazitive Verbindung (C4) miteinander verbunden sind und daß die Basis-Elektroden durch dieselbe Schaltung (Fig. 6) gemeinsam polarisiert werden, wobei diese Schaltung die Verstärkung des Verstärkers durch Beeinflussung der Polarisation der Basis-Elektroden steuert.

7

EP 0 275 587 B1

FIG.1

FIG.2

FIG.3

FIG.4

FIG.5

FIG.6

FIG.7